# FASCICULE DE BREVET EUROPEEN

(11) **EP 3 288 191 B1**
(45) Date de publication et mention de la délivrance du brevet: **19.10.2022**
(21) Numéro de dépôt: 17185711.3
(22) Date de dépôt: 10.08.2017
(51) Int. Cl.: H04B 7/185, H03D 7/12, B64G 1/10

(54) **DISPOSITIF DE CONVERSION DE FREQUENCES A DOUBLE OSCILLATEUR LOCAL ET CHARGE UTILE DE SATELLITE COMPRENANT UN TEL DISPOSITIF**
VORRICHTUNG ZUR FREQUENZUMWANDLUNG MIT DOPPELTEM LOKALEM OSZILLATOR, UND NUTZLAST EINES SATELLITEN, DER EINE SOLCHE VORRICHTUNG UMFASST
FREQUENCY CONVERSION DEVICE WITH DUAL LOCAL OSCILLATOR AND SATELLITE PAYLOAD COMPRISING SUCH A DEVICE

(30) Priorité: 23.08.2016 FR 1601250
(43) Date de publication de la demande: 28.02.2018
(73) Titulaire: Thales, 92400 Courbevoie (FR)
(72) Inventeur: ULIAN, Patrice, 31037 Toulouse (FR); VALLON-ALTAIRAC, Juliette, 31037 Toulouse (FR); JURAVER, Jean-Brice, 31037 Toulouse (FR)
(74) Mandataire: Atout PI Laplace

(56) Documents cités:
- EP-A2- 2 014 553
- US-A- 4 002 980
- US-A- 5 963 845
- US-A1- 2009 160 397

## Description

Le domaine technique de l'invention concerne les convertisseurs de fréquence embarqués dans les charges utiles de satellites, en particulier de satellites de télécommunication.

L'invention a plus précisément pour objet un convertisseur de fréquences à double oscillateur local.

Les convertisseurs de fréquence sont utilisés à bord des satellites de télécommunication pour réaliser une fonction de transposition de fréquence pour transmettre des signaux vers le sol dans différents canaux fréquentiels imposés par l'opérateur de télécommunications.

Le nombre de canaux fréquentiels différents qui doivent être gérés peut être très important, leur allocation en provenance du sol et leur allocation en retour vers le sol peut être variée, et ainsi, le nombre de convertisseurs de fréquence à bord d'un satellite peut, en conséquence, être également élevé.

En outre, afin d'assurer une continuité de service en cas de défaillance d'un équipement, les opérateurs satellites imposent l'utilisation d'équipements redondants qui viennent encore accroître le nombre total d'équipements qu'il est nécessaire d'embarquer à bord d'un satellite.

Au vu de ces contraintes, il existe un problème général qui consiste à limiter la masse, le volume et le coût global des convertisseurs de fréquence embarqués dans une charge utile de satellite pour réaliser les fonctions de conversion de fréquence associées au nombre de canaux fréquentiels imposés.

Les solutions actuelles permettant d'assurer un niveau de fiabilité requis consistent à embarquer dans une charge utile de satellite, un certain nombre de convertisseurs de fréquence supplémentaires qui restent éteints (inactifs) jusqu'à suppléer un autre convertisseur de fréquence défaillant.

Ces solutions engendrent un encombrement, en masse et volume, important pour la charge utile car elles nécessitent d'ajouter un nombre non négligeable de convertisseurs supplémentaires. En effet, chaque convertisseur est typé par un oscillateur local fonctionnant à une certaine fréquence. Un convertisseur redondant ne peut suppléer qu'un convertisseur défaillant comprenant le même type d'oscillateur local.

On connait par ailleurs les solutions décrites respectivement dans les demandes de brevet US 5963 845 et US 2009/160397.

L'invention propose une solution pour remédier aux inconvénients précités qui consiste en un convertisseur de fréquences à double oscillateur local qui permet de piloter plusieurs chaines de conversion de fréquence avec un même oscillateur local et ainsi de réaliser des économies en masse, volume et coût sur les équipements embarqués à bord du satellite.

L'invention a pour objet un dispositif de conversion de fréquences, tel que décrit dans la revendication 1.

L'invention a également pour objet une charge utile de satellite comprenant un dispositif de conversion de fréquences selon l'invention.

D'autres caractéristiques et avantages de la présente invention apparaîtront mieux à la lecture de la description qui suit en relation aux dessins annexés qui représentent :
- les figures 1 et 2, deux schémas représentant comme exemples comparatives non conformes avec l'invention respectivement un
   anneau de convertisseurs de fréquence comprenant une chaine active (figure 1) et trois chaines actives (figure 2) selon une première solution de l'art antérieur,
- les figures 3 et 4, deux schémas représentant comme exemples comparatives non conformes avec l'invention respectivement un
   anneau de convertisseurs de fréquence comprenant une chaine active (figure 3) et trois chaines actives (figure 4) selon une seconde solution de l'art antérieur,
- la figure 5, un schéma représentant un dispositif de conversion de fréquence à double oscillateur local représentant une partie des caractéristiques d'un mode de réalisation de l'invention,
- la figure 6, un schéma selon l'invention représentant une première utilisation du
   dispositif de conversion de fréquence de la figure 3 pour réaliser un système plus complexe gérant une chaine active à une première fréquence et trois chaines actives à une seconde fréquence,
- la figure 7, un schéma représentant un dispositif de conversion de fréquence à double oscillateur local qui ne correspond pas à un mode de réalisation de l'invention.

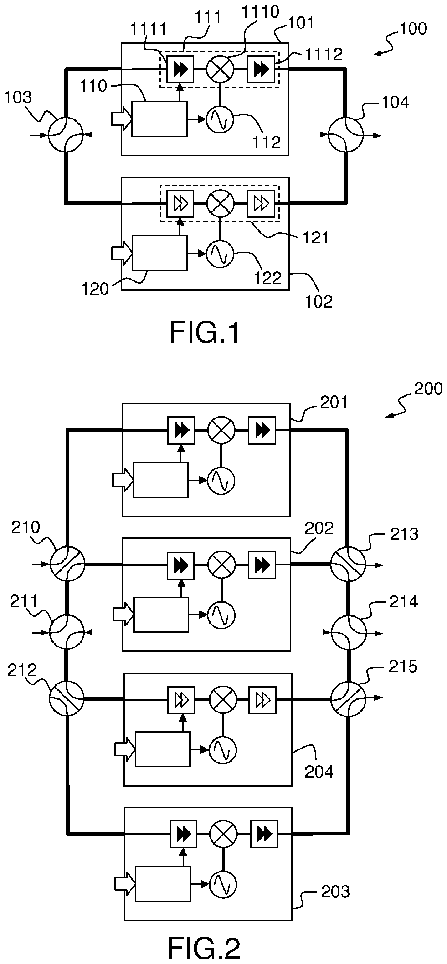

Les figures 1 et 2 représentent deux exemples comparatives de systèmes de conversion de fréquence selon une première technique de l'art antérieur.

La figure 1 décrit un dispositif 100 de convertisseurs de fréquences destiné à réaliser une transposition de fréquences pour un signal diffusé dans un canal fréquentiel. L'opération de transposition de fréquences consiste à obtenir en sortie du dispositif 100 un signal à une fréquence Fₛ = Fₑ + F_{OL}, avec Fₑ la fréquence du signal en entrée du dispositif 100 et F_{OL} la fréquence de l'oscillateur local 112,122 utilisé pour réaliser la conversion de fréquence. Alternativement, l'opération peut aussi être réalisée en soustrayant la fréquence de l'oscillateur local F_{OL} à la fréquence d'entrée Fₑ du dispositif, avec Fₛ = Fₑ - F_{OL}.

Selon l'exemple de la figure 1, le dispositif 100 de convertisseurs de fréquences comprend un premier équipement 101 comprenant un convertisseur de courant ou tension 110 apte à produire un courant continu à une intensité donnée ou une tension continue à une tension donnée pour alimenter l'équipement 101. Le convertisseur de courant ou tension 110 alimente une chaine de conversion de fréquences 111 et un oscillateur local 112 produisant la fréquence F_{OL}. La chaine de conversion de fréquences 111 comprend au moins un mélangeur 1110 pour transposer la fréquence du signal reçu en entrée du dispositif à partir de la fréquence de l'oscillateur local 112. La chaine de conversion de fréquences 111 peut aussi comprendre un ou plusieurs filtre(s) et amplificateur(s) 1111,1112.

Pour assurer une continuité de service en cas de défaillance du premier équipement 101, le dispositif 100 de convertisseurs de fréquences comprend également un second équipement 102, identique au premier équipement 101, mais utilisé en tant qu'équipement redondant. Le second équipement est rendu inactif lorsque le premier équipement 101 est actif. Si le premier équipement 101 devient défaillant, le second équipement 102 est rendu actif. Un équipement est rendu inactif en éteignant son alimentation. Ainsi, un équipement inactif est préservé de l'usure du temps et présente une meilleure fiabilité pour être utilisé pour suppléer un équipement actif défaillant.

L'activation du premier équipement 101 ou du second équipement 102 peut s'accompagner notamment de la commutation de plusieurs interrupteurs 103,104 qui sont agencés pour connecter l'entrée (respectivement la sortie) du dispositif 100 de convertisseurs de fréquences vers l'entrée (respectivement la sortie) du premier équipement 101 ou du second équipement 102.

Le second équipement 102 est identique au premier équipement 101 et comprend à cet effet un convertisseur de courant ou tension 120, une chaine de conversion de fréquences 121 et un oscillateur local 122 apte à générer la même fréquence F_{OL} que l'oscillateur local 112 du premier équipement 101.

La figure 2 représente un autre exemple comparative de dispositif 200 de convertisseurs de fréquences selon l'art antérieur. Sur cet exemple, le dispositif 200 comprend trois équipements actifs 201,202,203 et un équipement redondant inactif 204. Les trois équipements actifs sont utilisés pour transposer trois signaux différents, correspondant par exemple à trois canaux fréquentiels distincts, avec la même fréquence de transposition F_{OL}.

Chaque équipement 201-204 est identique aux deux équipements décrits pour le dispositif de la figure 1. Le dispositif 200 comporte plusieurs interrupteurs 210,211,212,213,214,215 pour gérer les connexions entre les trois entrées (respectivement trois sorties) du dispositif 200 et les trois entrées (respectivement trois sorties) des trois équipements actifs 201,202,203.

Les exemples des figures 1 et 2 illustrent la problématique de l'encombrement, en masse et en volume, lié à la multiplication des convertisseurs de fréquence embarqués à bord d'un satellite pour gérer, non seulement une multiplicité de signaux nécessitant chacun une opération de transposition fréquentielle, mais également la nécessité d'embarquer en outre des équipements redondants pour assurer une continuité de service avec un niveau de fiabilité élevé.

Typiquement, une charge utile de satellite peut embarquer plusieurs dispositifs de convertisseurs de fréquence chacun associé à un signal différent à transposer, imposant l'emport de plusieurs dizaines de convertisseurs de fréquence. En outre, les contraintes de fiabilité imposent au moins un équipement redondant pour un équipement actif.

Ainsi, se pose le problème de l'encombrement (masse et volume) engendré par la multitude de convertisseurs nécessaires. Il est donc nécessaire de trouver une solution permettant de diminuer la masse et le volume de l'ensemble des dispositifs tout en conservant le même niveau de fiabilité requis vis-à-vis de la redondance exigée.

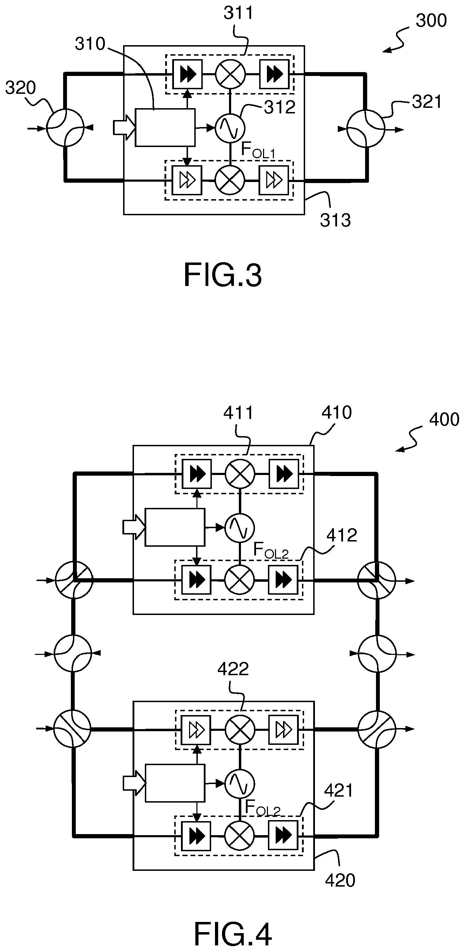

Les figures 3 et 4 représentent deux autres exemples comparatives de convertisseurs de fréquences selon une autre technique de l'art antérieur.

Afin de limiter l'encombrement, en masse et volume, global généré par l'ensemble des convertisseurs de fréquences embarqués à bord d'un satellite, une solution consiste à réaliser des convertisseurs à double chaine de transposition de fréquence. Un tel dispositif 300 est décrit à la figure 3. Il comprend deux chaines de transposition de fréquence 311,313 qui sont chacune alimentée par le même convertisseur de courant ou tension 310 et par un même oscillateur local 312. Une première chaine de transposition de fréquence 311 est rendue active tandis que la seconde chaine 313 est rendue inactive. Un système d'interrupteurs 320,321 permet, de façon similaire au dispositif de la figure 1, de connecter les entrées/sorties du dispositif 300 aux entrées/sorties de la chaine de transposition active 311.

Le dispositif 300 de la figure 3 permet de diminuer l'encombrement (masse et volume) en utilisant un seul convertisseur de courant ou tension 310 et un seul oscillateur local 312 pour deux chaines de transposition 311,313.

La figure 4 représente un autre exemple d'application conparative du dispositif décrit à la figure 3 mais cette fois pour gérer trois chaines de transposition actives et une chaine redondante inactive. Dans ce cas, le dispositif 400 selon la figure 4 comprend un premier équipement 410 comprenant deux chaines actives 411,412 et un second équipement 420 comprenant une chaine active 421 et une chaine inactive 422.

Un système d'interrupteurs identique à celui utilisé pour le dispositif de la figure 2 sert à connecter les entrées et sorties du dispositif aux entrées et sorties des chaines actives.

Un inconvénient du dispositif de conversion de fréquence à double chaine de transposition tel que décrit aux figures 3 et 4 est qu'il ne permet pas d'assurer une redondance stricte en séparant totalement les équipements actifs des équipements inactifs. En effet, dans le cas du dispositif de la figure 2, la redondance induite est de un équipement supplémentaire pour pallier à une défaillance d'un autre équipement parmi trois. Dans le cas du dispositif de la figure 4, la redondance n'est plus que d'un équipement supplémentaire pour pallier à une défaillance d'un seul autre équipement. En effet, si une chaine de transposition est défaillante, l'architecture du dispositif de la figure 4 peut entraîner la défaillance in fine de deux chaines de transpositions puisqu'elles sont co-localisées au sein du même dispositif.

En outre, la notion de redondance implique le plus souvent, pour assurer une fiabilité optimale, que l'équipement redondant soit totalement éteint afin de préserver son fonctionnement. Dans le cas d'un dispositif à double chaine de transposition, seule une partie du dispositif est éteinte, ce qui ne permet pas d'assurer la même fiabilité de fonctionnement du dispositif redondant.

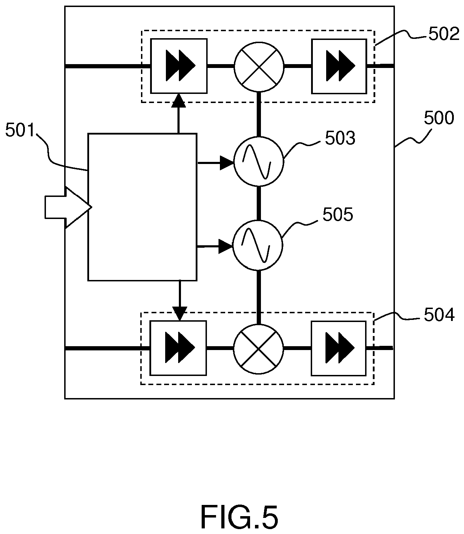

La figure 5 décrit un dispositif de conversion de fréquences à double chaine de transposition et à double oscillateur local, représentant une partie des caractéristiques d'un mode de réalisation de l'invention.

Le dispositif 500 selon l'invention comprend un unique convertisseur de courant ou tension 501 qui vient alimenter deux chaines de conversion de fréquence 502,504 et deux oscillateurs locaux 503,505 qui viennent piloter chacun une des deux chaines. Les chaines de conversion de fréquence 502,504 sont identiques à celles déjà décrites à la figure 1 et comprennent au moins un mélangeur et, optionnellement, au moins un filtre et/ou au moins un amplificateur.

Les fréquences des deux oscillateurs locaux 503,505 peuvent être identiques ou différentes.

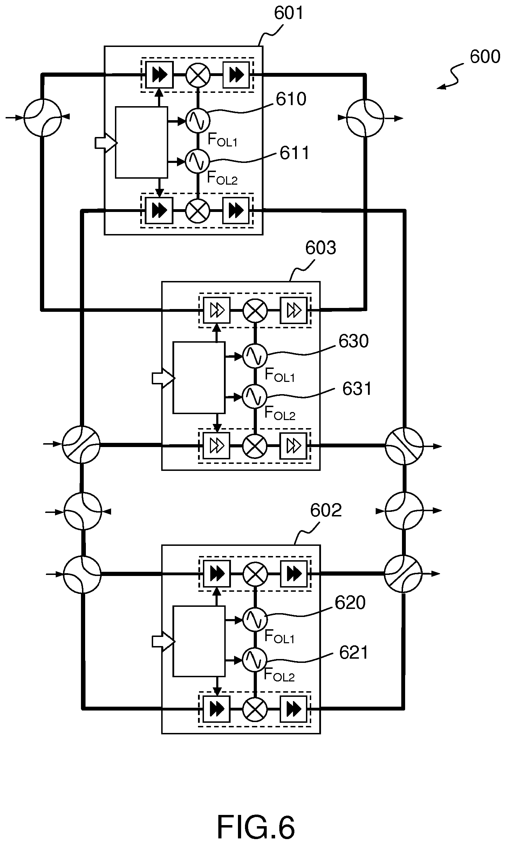

Le dispositif selon l'invention décrit à la figure 5 permet de réaliser plusieurs fonctions de transposition de fréquence avec deux fréquences de conversion différentes au sein d'une même charge utile de satellite. Le dispositif selon l'invention permet de réaliser un gain en encombrement (masse et volume) du fait de l'utilisation d'un même convertisseur de courant ou tension pour alimenter deux chaines de conversion de fréquence et deux oscillateurs locaux. En outre, le dispositif selon l'invention permet, contrairement aux solutions de l'état de l'art décrites aux figures 3 et 4, d'assurer une redondance stricte, dite redondance froide, des équipements comme cela est illustré sur l'exemple de la figure 6.

La figure 6 décrit un ensemble 600 de convertisseurs de fréquence comprenant trois dispositifs 601,602,603 du type de la figure 5 selon l'invention.

L'ensemble 600 permet de réaliser les mêmes fonctions de conversion de fréquence que les deux dispositifs des figures 3 et 4, à savoir une conversion à une première fréquence F_{OL1} et trois conversions à une seconde fréquence F_{OL2}.

Le premier dispositif 601 comporte une première chaine de conversion pilotée par un premier oscillateur local 610 produisant la première fréquence F_{OL1} et une seconde chaine de conversion pilotée par un second oscillateur local 611 produisant la seconde fréquence F_{OL2}. Le deuxième dispositif 602 comporte deux chaines de conversion chacune pilotée par un oscillateur local 620,621 produisant la seconde fréquence F_{OL2}. Enfin, le troisième dispositif 603 comporte une première chaine de conversion pilotée par un premier oscillateur local 630 produisant la première fréquence F_{OL1} et une seconde chaine de conversion pilotée par un second oscillateur local 631 produisant la seconde fréquence F_{OL2}.

Le premier dispositif 601 et le deuxième dispositif 602 sont actifs et permettent ensemble de réaliser la première chaine de conversion de fréquence via la première fréquence F_{OL1} et les trois chaines de conversion de fréquence via la seconde fréquence F_{OL2}.

Le troisième dispositif 603 est utilisé en tant que dispositif redondant et est rendu inactif. Il permet d'assurer une redondance à la fois pour la chaine de conversion à la première fréquence F_{OL1} et pour les trois chaines de conversion à la seconde fréquence F_{OL2}.

Contrairement au système décrit aux figures 3 et 4, le dispositif selon l'invention permet de réaliser une redondance stricte, dite redondance froide, en ce qu'un dispositif complet 603 peut être utilisé comme dispositif redondant. Un gain en encombrement (masse et volume) est obtenu du fait qu'un même dispositif peut être utilisé pour une seule fréquence de conversion ou deux fréquences de conversion différentes.

Sans sortir du cadre de l'invention, le dispositif décrit à la figure 5 peut être utilisé pour réaliser des systèmes plus complexes comprenant un grand nombre de chaines de conversion de fréquence.

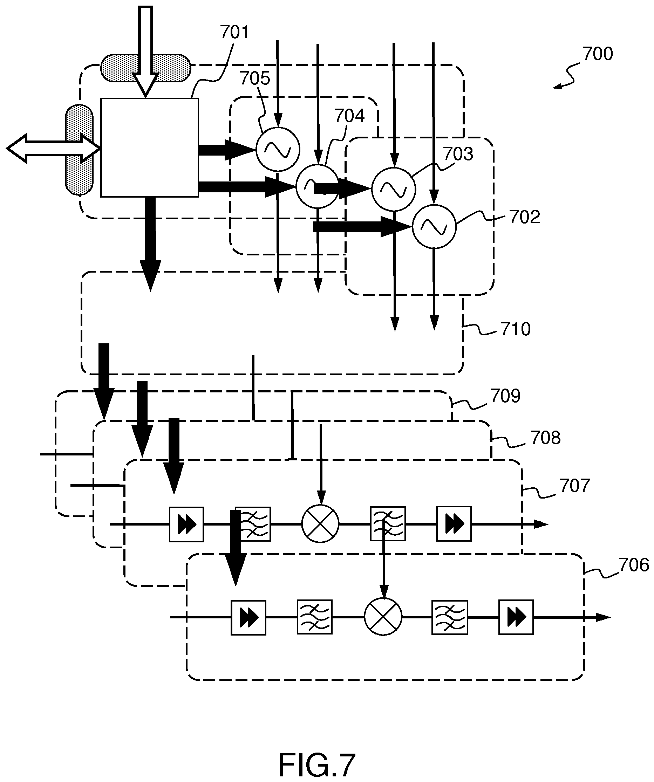

La figure 7 décrit un dispositif de conversion de fréquences qui ne correspond pas à un mode de réalisation de l'invention.

Le dispositif 700 de la figure 7 comprend un convertisseur de courant ou tension 701 actif pour alimenter l'ensemble des composants du dispositif, un premier oscillateur local 702 actif fonctionnant à une première fréquence F_{OL1}, un deuxième oscillateur local 703 actif fonctionnant à une seconde fréquence F_{OL2}, un troisième oscillateur local 704 fonctionnant à la première fréquence F_{OL1} et rendu inactif pour assurer une redondance du premier oscillateur local 702, un quatrième oscillateur local 705 fonctionnant à la seconde fréquence F_{OL2} et rendu inactif pour assurer une redondance du deuxième oscillateur local 703. Le convertisseur de courant ou tension 701 actif peut être redondé en ajoutant un second convertisseur de courant ou tension inactif redondant afin de pallier une défaillance du convertisseur 701 actif.

Le dispositif 700 comprend également une pluralité de chaines de conversion de fréquence 706-709 et un système 710 de distribution pour relier les sorties des différents oscillateurs locaux 702-705 aux mélangeurs des différentes chaines de conversion de fréquence 706-709.

Le dispositif 700 de la figure 7 est notamment avantageux pour embarquer un grand nombre de chaines de conversion de fréquence. Il permet de mutualiser un même convertisseur de courant 701 pour l'ensemble des chaines et permet également d'assurer une redondance stricte pour les oscillateurs locaux et les chaines de conversion de fréquence. En outre, il présente l'avantage de garantir une grande souplesse dans la réalisation car il est possible de réaliser un grand nombre de combinaisons en faisant varier le nombre de chaines de conversion associées à la première fréquence de conversion F_{OL1} et à la seconde fréquence de conversion F_{OL2} mais également en faisant varier le nombre de chaines de conversion redondantes qui sont reliées aux oscillateurs locaux redondants.

## Revendications

1. Dispositif (600)
de conversion de fréquences, destiné à être embarqué à bord d'un satellite, comprenant un ensemble actif comprenant au moins une première chaine de traitement radiofréquence (502) comprenant un premier mélangeur, un premier oscillateur local (503, 610)
opérant à une première fréquence et relié au premier mélangeur, au moins une deuxième chaine de traitement radiofréquence (504) comprenant un deuxième mélangeur, et un deuxième oscillateur local (505, 611)
opérant à une seconde fréquence et relié au deuxième mélangeur et un convertisseur de courant ou tension (501) pour alimenter l'ensemble actif, le dispositif étant **caractérisé en ce que** dans l'ensemble actif ledit convertisseur de courant ou tension (501), ladite première chaine de traitement radiofréquence (502), ledit premier oscillateur local (503, 610), ladite deuxième chaine de traitement radiofréquence (504) et ledit deuxième oscillateur local (505, 611) sont regroupés au sein d'un même premier équipement (601), le dispositif (600) comprenant au moins un équipement supplémentaire (602,603) identique au premier équipement (601), chaque équipement supplémentaire étant rendu soit actif, soit redondant inactif.

2. Dispositif (600) de conversion de fréquences selon la revendication 1 comprenant une pluralité d'interrupteurs pour connecter les entrées/sorties du dispositif aux entrées/sorties des équipements actifs (601,602,603).

3. Charge utile de satellite comprenant un dispositif (600) de conversion de fréquences selon l'une des revendications précédentes.

## Patentansprüche

1. Vorrichtung (600) zur Umwandlung von Frequenzen, welche dazu bestimmt ist, an Bord eines Satelliten mitgeführt zu werden, umfassend eine aktive Gruppe, die mindestens eine erste Hochfrequenz-Verarbeitungskette (502), welche einen ersten Mischer umfasst, einen ersten lokalen Oszillator (503, 610), welcher auf einer ersten Frequenz arbeitet und mit dem ersten Mischer verbunden ist, mindestens eine zweite Hochfrequenz-Verarbeitungskette (504), welche einen zweiten Mischer umfasst, und einen zweiten lokalen Oszillator (505, 611) umfasst, welcher auf einer zweiten Frequenz arbeitet und mit dem zweiten Mischer und mit einem Strom- oder Spannungsumwandler (501) verbunden ist, um die aktive Gruppe zu speisen, wobei die Vorrichtung **dadurch gekennzeichnet ist, dass** in der aktiven Gruppe der Strom-oder Spannungsumwandler (501), die erste Hochfrequenz-Verarbeitungskette (502), der erste lokale Oszillator (503, 610), die zweite Hochfrequenz-Verarbeitungskette (504) und der zweite lokale Oszillator (505, 611) innerhalb einer ersten Ausrüstung (601) zusammengefasst sind, wobei die Vorrichtung (600) mindestens eine mit der ersten Ausrüstung (601) identische Zusatzausrüstung (602, 603) umfasst, wobei jede Zusatzausrüstung entweder aktiv oder redundant inaktiv gemacht wird.

2. Vorrichtung (600) zur Umwandlung von Frequenzen nach Anspruch 1, umfassend eine Vielzahl von Schaltern zum Verbinden der Eingänge/Ausgänge der Vorrichtung mit den Eingängen/Ausgängen der aktiven Ausrüstungen (601, 602, 603).

3. Nutzlast eines Satelliten, umfassend eine Vorrichtung (600) zur Umwandlung von Frequenzen nach einem der vorhergehenden Ansprüche.

## Claims

1. A frequency conversion device (600), intended to be loaded on board a satellite, comprising an active assembly comprising at least a first radiofrequency processing chain (502) comprising a first mixer, a first local oscillator (503, 610) operating at a first frequency and connected to the first mixer, at least a second radiofrequency processing chain (504) comprising a second mixer, and a second local oscillator (505, 611) operating at a second frequency and connected to the second mixer and to a current or voltage converter (501) to power the active assembly, the device being **characterised in that** in the active assembly said current or voltage converter (501), said first radiofrequency processing chain (502), said first local oscillator (503, 610), said second radiofrequency processing chain (504) and said second local oscillator (505, 611) are grouped together within a first piece of equipment (601), the device (600) comprising at least one additional piece of equipment (602, 603) identical to the first piece of equipment (601), each additional piece of equipment being made either active or redundant inactive.

2. The frequency conversion device (600) according to claim 1 comprising a plurality of switches for connecting the inputs/outputs of the device to the inputs/outputs of the active pieces of equipment (601, 602, 603).

3. A satellite payload comprising a frequency conversion device (600) according to one of the preceding claims.
